# EUROPEAN PATENT APPLICATION

(11) **EP 0 789 323 A2**
(43) Date of publication of application: **13.08.1997**
(21) Application number: 97300627.3
(22) Date of filing: 30.01.1997
(51) Int. Cl.: G06K 19/077

(54) **Contact card**

(30) Priority: 12.02.1996 GB 9602800
(71) Applicant: GPT LIMITED, Coventry, CV3 1HJ (GB)
(72) Inventor: Stacey, Graham John, Daventry, Northamptonshire NN11 4HJ (GB)
(74) Representative: Walker, Andrew John

(57) **Abstract**

A contact card is manufactured by impressing a contact assembly (13) through a smaller aperture (35) pre-formed in a facing layer (31). The contact assembly (13) has its electronic components (16, 17) enclosed in a glob (18). The contact card is assembled by pressing the contact assembly (13) into a polyvinylchloride core (30) which is heated to allow the glob (18) to be impressed into the material of the core (30), the excess material being displaced laterally between the facing layer (31) and backing layer (32). This method enables a contact card (Figure 3) to be manufactured without the edge of the aperture (35) being damaged during formation or exposing a sharp edge after assembly. Instead, the insertion of the contact assembly (13) distends the aperture (35) to leave a curved transition (36).

## Description

This invention relates to contact cards and their manufacture.

Contact cards are usually the size and thickness of a credit card and have many applications. For instance, they can be used as telephone cards, or as travel cards, or as smart cards which latter incorporate a data processor.

A contact card essentially has a number of external contacts on one of its major faces, such contacts being positioned for engagement with an equivalent pattern of terminals in an appropriate card reader.

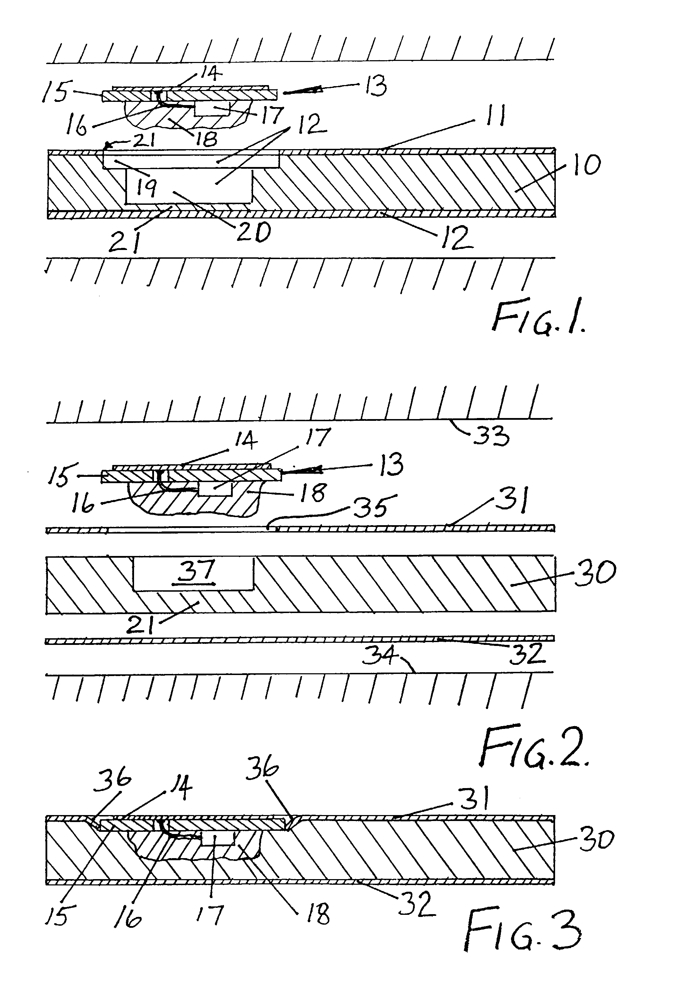

Conventionally contact cards are manufactured by inserting a contact assembly into a machined recess in the card with the contacts appropriately orientated relative to the profile of the card, the contact assembly currently being retained in the recess by adhesion with the body of the card. The construction and manufacture of such conventional cards is subsequently described herein with reference to Figure 1 of the accompanying drawings. Such conventional constructions have the disadvantages that considerable precision is necessary in forming the recess of the correct profile and depth; that, as the cards are usually formed of a core laminated between a facing layer and a backing layer, the machining of the recess can cause delamination between the facing layer and the core thereby generating a ragged edge to the recess; that, as the recess must be large enough to accept the insertion of the contact assembly, there is usually a slight gap between the edge of the recess and the inserted contact assembly thereby leaving a noticeable sharp edge around the recess; and that the conventional use of thermosetting adhesive to secure the contact assembly within the recess frequently causes distortion of the backing layer.

The present invention provides a method of manufacturing a contact card, and a contact card construction which can mitigate the above disadvantages.

According to one aspect of the invention a contact card comprises a core laminated between a facing layer and a backing layer, the facing layer defining an aperture formed prior to lamination, and a contact assembly pressed through the aperture and embedded in the core.

Preferably the core is formed with a recess prior to lamination, the recess being aligned with the pre-formed aperture in the facing layer, and the contact assembly being embedded within the recess. In this case the core may be formed from two laminates one of which has been formed with an aperture prior to lamination to define the recess. The aperture in the facing layer is preferably of the same profile, but slightly smaller than, the profile of the contact assembly, and the edges of the aperture have been pressed by the edges of the contact assembly into the core. The core may be formed from polyalkyl ethylphthalate. The core may be formed from polyvinylchloride. Preferably the backing layer is formed from polyalkyl ethylphthalate. The core may be adhered to the polyalkyl ethylphthalate by a nitrile phenolic cross linking hot melt.

The contact assembly may include a chip encapsulated in a UV curing flexibilised epoxy.

According to another aspect of the invention a method of manufacturing a contact card includes forming a card facing layer with an aperture of the same profile, but slightly smaller than, the profile of a separate contact assembly, laminating the card facing layer to a card core and forcing the separate contact assembly through the aperture into the core whilst the core is at a temperature which will allow it to be displaced by the impression of the contact assembly.

The method may include forming a recess in the core prior to lamination, the recess being positioned to reduce the volume of the core to be displaced by the impression of the contact assembly.

The method may include forming the core from two separate laminates and forming an aperture through one of the laminates, prior to lamination, to define the recess.

The method may include arranging a thermally activated adhesive between the facing layer and the core.

The method may include encapsulating an electronic component on the face of the contact assembly that is to be impressed into the core with a material which will not flow at the temperature used for impressing the contact assembly into the core.

The invention will now be described, by way of example only, with reference to the accompanying drawings in which: -
Figure 1 illustrates the manufacture and construction of known contact cards;
Figure 2 illustrates one method of manufacturing a contact card in accordance with the present invention;
Figure 3 is a longitudinal section through a contact card manufactured in accordance with the method of Figure 2;
Figure 4 illustrates a modified method of manufacturing a contact card in accordance with the present invention; and
Figure 5 is a longitudinal section through a contact card manufactured in accordance with the method of Figure 4.

The conventional contact card illustrated in Figure 1 comprises a core (10) laminated between a facing layer (11) and a backing layer (12), the lamination typically being performed under pressure with appropriate heating to effect curing of resin applied between the core (10) and the layers (11) and (12). After the lamination has been completed, a recess (12) is machined for receiving a contact assembly (13) which comprises a number of electrical contacts (14) (only one shown) supported by the outer face of a rigid layer (15). The contacts (14) are connected by wires (16) which extend through appropriate holes in the rigid layer (15) and are connected to one or more electronic components such as a chip (17). The wires (16) and electronic component (17) are then protected by a glob (18) of appropriate material which is adhered to the back face of the rigid layer (15). The recess (12) is typically machined by a vertical milling cutter and defines a shallow portion (19) to receive the periphery of the rigid layer (15), and a deeper portion (20) to receive the glob (18), the entire contact assembly (13) being secured within the recess (12) by a thermo-setting adhesive. The machining of the recess (12) requires considerable precision as the profile of the shallow portion (19) must correspond very closely to the profile of the rigid layer (15) of the contact assembly (13) and, moreover, must be of a depth which will leave the contacts (14) generally co-planar with the outer surface of the facing layer (11). Because the profile of the shallow portion (19) is necessarily slightly larger than the profile of the rigid layer (15) of the contact assembly (13), there is a slight gap between the edge (21) of the portion (19) and the periphery of the rigid layer (15). There is consequently a slight gap between the edge (21) and the periphery of the rigid layer (15) which can entrap dirt which can subsequently be drawn across the reader terminals when the contact card is inserted. Also dirt can be rolled out of the gap by this process and can damage the contacts (14). Furthermore, the edge (21) is undesirable as it is noticeable to the card bearer. During milling of the shallow portion (19), the cutter can cause delamination between the facing layer (11) and the core (10) around the periphery of the recess portion (19). This leads to the card being damaged and typically the edge (21) will be ragged wherever it is not firmly adhered to the core (10). As well as being unsightly, such ragged edge can extend beyond the edge of the recess portion (19) and can interfere with the subsequent insertion of the contact assembly (13). The milling of the deeper portion (20) of the recess (12) must be sufficiently deep to receive the glob (18) and the thermosetting resin, but must conversely be sufficiently shallow that it does not physically interfere with the backing layer (12). It will therefore be appreciated that the machining of the recess (12) is a precision operation which is essentially costly and can result in the entire card body being damaged to the extent that it has to be scrapped. A further problem with this conventional card arises during the insertion of the contact assembly (13) into the recess (12) which typically involves the application of pressure and heat to effect the setting of the adhesive. This process typically causes overheating of the thin web (21) and consequent distortion and disfiguration of the adjoining portion of the backing layer (12). When this occurs the completed card may also need to be scrapped.

All of the problems described with reference to Figure 1 can be avoided by using the method and construction taught by the present invention.

In Figure 2 a contact card is formed by laminating a core (30) between a facing layer (31) and a backing layer (32). The core is formed from polyvinylchloride and the layers (31, 32) from a polyester such as polyalkyl ethylphthalate. A suitable thermally activated adhesive is interposed between the layers (31, 32) and the core (30). Conveniently the thermally activated adhesive can be co-extruded with the material from which the layers (31, 32) are formed and can be the product sold under the trade mark MELANEX 347 supplied by ICI plc. The grade of polyvinylchloride used for the core (30) is chosen so that it will typically flow at a temperature of 70 °C, and its lamination to the layers (31, 32) is achieved by pressing the platens (33, 34) together whilst the materials are heated to a temperature between 150 and 170°C.

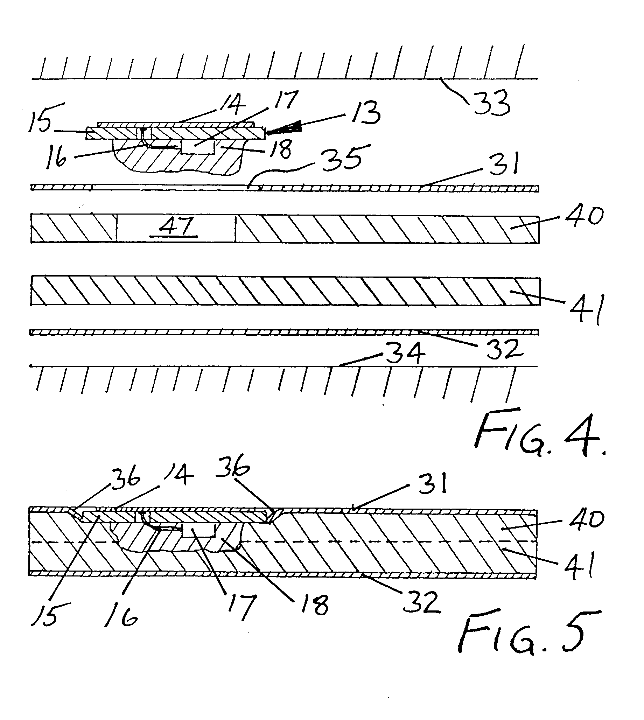

Prior to lamination, appropriate graphics will have been printed on the outer faces of the layers (31, 32) and preferably protected by the lamination of a thin transparent membrane. Also prior to lamination, the facing layer (31) has an aperture (35) punched through it in the position where the contact assembly is to be mounted to the card. The punched aperture (35) is of the same profile as the edge of the rigid layer (15) of the contact card assembly (13) but is made slightly smaller. Due to this feature a contact assembly (13), as shown in Figure 3, becomes impressed into the core (30) as shown, the edge of the rigid layer (15) of the contact assembly (13) serving to enlarge the aperture (35) as shown. In this manner the edges of the aperture (35) are drawn downwards until they either abut the edges of the rigid layers (15), as shown in Figure 3, or are otherwise deflected downwards into the softened core (30). It will therefore be appreciated that the manufacturing process is improved as there is no need to perform a precision milling operation to form a recess to receive the contact assembly (13), and that the drawing down of the edges of the aperture (35) leaves a smooth transition (36) between the facing layer (31) and the contact assembly (13). This change of manufacturing technique precludes the danger of tearing the edge (21) due to poor lamination and, moreover, has the effect of enhancing lamination of the facing layer (31) with the core around the position of insertion because the edges of the aperture (35) are effectively forced downwards against the surface of the core (30) and are also trapped in position by their contact with the rigid layer (15) of the contact assembly (13).

To enable the contact assembly (13) to be impressed into the core (30), it is necessary to ensure that the glob (18) has sufficient rigidity and is formed of a material which has a glass transition temperature greater than the temperature used for lamination. We have found that a UV curing flexibilsed epoxy (sold under the trade mark VITRALIT 1550S) is suitable but other encapsulants having the appropriate physical properties may of course be used. On the other hand, the rest of the contact assembly (13) can be manufactured in the usual way, for instance by using a gold plated copper foil to provide the contacts (14) and by pre-piercing the rigid layer (15) to enable the wires (60) to be connected to the chip (17).

Although the contact assembly (13) can be simply impressed into the core (30), we prefer to provide the core (30) with a recess (37) as shown in Figure 2. This recess can be formed in any convenient manner, for instance by moulding or pre-pressing into the core (30) however, it should be noted that the web (21) is essentially thicker insofar as the recess (37) will be performed by the impression of the glob (18) of the contact assembly (13). In this manner the material of the core (30) is able to flow outward and is not subject to the overheating problems associated with the conventional construction shown with reference to Figure 1.

Irrespective of whether the recess (37) is preformed in the core (30), or the core (30) is left blank, the construction of the resulting contact card is as shown in Figure 3. The only difference is the extent to which the laminate must be pressed to cause lateral displacement of the softened core (30) to accommodate the contact assembly (13).

The method may be modified, for instance in the manner illustrated in Figure 4, in which the core has been formed from two separate lamella (40, 41) which are conveniently of equal thickness. With this technique it is possible to form the recess by punching an aperture (37) through the upper layer (40), this being a simpler process than forming the recess (37) in the core (30) as taught in Figure 2. The process is otherwise identical to that described with reference to Figure 2 and the resultant contact card, as shown in Figure 5, is identical except insofar as there will be an interface (50) where the layers (40, 41) have been adhered together. The method and construction taught with reference to Figures 4 and 5 is particularly useful when the resultant card is to have both a contact assembly (13) and a contactless arrangement which would typically be sandwiched between the layers (40, 41). The contactless arrangement would include an aerial and associated electronic components which would typically be mounted on a substrate sandwiched between the layers (40, 41) remote from the contact assembly (13).

## Claims

1. A contact card comprising a core (30) laminated between a facing layer (31) and a backing layer (32), the facing layer (31) defining an aperture (35) formed prior to lamination, and a contact assembly (13) pressed through the aperture (35) and embedded in the core (30).

2. A contact card, as in Claim 1, in which the core (30) was formed with a recess (37) prior to lamination, the recess (37) being aligned with the pre-formed aperture (35) in the facing layer (31), and the contact assembly (13) being embedded within the recess (37).

3. A contact card, as in Claim 2, in which the core (30) is formed from two laminates (40, 41) one of which (40) has been formed with an aperture (47) prior to lamination to define the recess (37).

4. A contact card, as in any preceding claim, in which the aperture (35) in the facing layer (31) is of the same profile, but slightly smaller than, the profile of the contact assembly (13), and the edges of the aperture (35) have been pressed by the edges of the contact assembly into the core (30).

5. A method of manufacturing a contact card including forming a card facing layer (31) with an aperture (35) of the same profile, but slightly smaller than, the profile of a separate contact assembly (13), laminating the card facing layer (31) to a card core (30) and forcing the separate contact assembly (13) through the aperture (35) into the core (30) whilst the core (30) is at a temperature which will allow it to be displaced by the impression of the contact assembly (13).

6. A method as in Claim 5, including forming a recess (37) in the core (30) prior to lamination, the recess (37) being positioned to reduce the volume of the core (30) to be displaced by the impression of the contact assembly (13).

7. A method, as in Claim 6, including forming the core (30) from two separate laminates (40, 41) and forming an aperture (47) through one of the laminates (40), prior to lamination, to define the recess (37).

8. A method, as in any of Claims 5 to 7, including arranging a thermally activated adhesive between the facing layer (31) and the core (30).

9. A method, as in any of Claims 5 to 8, including encapsulating an electronic component on the face of the contact assembly (13) that is to be impressed into the core (30) with a material which will not flow at the temperature used for impressing the contact assembly (13) into the core (30).

10. A contact card manufactured by the method of any of Claims 5 to 9.
